(19) Europäisches Patentamt
European Patent Office
Office européen des brevets

(11) **EP 0 981 056 B1**

(12) **EUROPÄISCHE PATENTSCHRIFT**

(45) Veröffentlichungstag und Bekanntmachung des Hinweises auf die Patenterteilung:
**28.01.2004 Patentblatt 2004/05**

(51) Int Cl.⁷: **G01R 31/34**, G01R 31/42

(21) Anmeldenummer: **99112329.0**

(22) Anmeldetag: **26.06.1999**

(54) **Verfahren zur Ermittlung eines Pumpenzustandes**

Method for determining the condition of a pump

Procédé pour déterminer l'état d'une pompe

(84) Benannte Vertragsstaaten:
**DE FR GB IT**

(30) Priorität: **20.08.1998 DE 19837796**

(43) Veröffentlichungstag der Anmeldung:
**23.02.2000 Patentblatt 2000/08**

(73) Patentinhaber: **WILO AG**
**44263 Dortmund (DE)**

(72) Erfinder: **Greitzke, Stephan**
**44287 Dortmund (DE)**

(74) Vertreter:
**COHAUSZ DAWIDOWICZ HANNIG & PARTNER**
**Patent- und Rechtsanwaltskanzlei**
**Schumannstrasse 97-99**
**40237 Düsseldorf (DE)**

(56) Entgegenhaltungen:
**EP-A- 0 833 436      EP-A- 0 915 348**
**WO-A-90/07813      DE-A- 3 436 776**
**DE-A- 4 132 745      US-A- 4 949 362**

**Beschreibung**

Die Erfindung betrifft ein Verfahren zur Überwachung eines vermittels eines Mikroprozessors gesteuerten und (ab)schaltbare Halbleiterelemente aufweisenden pulsbreitengesteuerten Frequenzumrichters eines drehzahlgeregelten Wechsel- oder Drehstrommotors, der insbesondere zum Antrieb von Kreiselpumpen dient, wobei die Steuerelektronik in einer Betriebsphase über eine mindestens zwei zu einer Brückenschaltung verschaltete Schaltelemente aufweisende Umrichterschaltung eine Versorgungsspannung an die Wicklungen des Elektromotors anlegt.

Bekanntermaßen können bei Elektromotoren und Elektromotor betriebenen Aggregaten wie Kreiselpumpen Defekte verschiedener Art auftreten, die zu mitunter erheblichen Betriebsstörungen führen. Besonders schwerwiegende Störungen werden von Kurzschlüssen oder Unterbrechungen in den Motorwicklungen, in den Verbindungseinrichtungen oder im Frequenzumrichter selbst verursacht. Fehlt beispielsweise eine Phase der Frequenzumrichter- Ausgangsspannung kann es zu einer thermischen Überlastung einer Motorwicklung (Zwei-Phasen-Lauf) kommen. Ein Kurzschluß kann den Motor blockieren und in extremen Fällen einen Brand im Motor auslösen.

Um einen Motor gegen die Folgen eines Kurzschlusses abzusichern ist es bekannt, die Frequenzumrichter der Steuerelektronik mit Schutz- oder Meldeeinrichtungen auszurüsten, die durch den hohen, z.B. durch einen Klemmen-Kurzschluß am Ausgang ein Frequenzumrichters erzeugten Strom ausgelöst werden. Die bekannten Einrichtungen bewirken ein Abschalten der Spannungsversorgung oder eine vernehmbare Störmeldung.

Problematisch an den bekannten Diagnose-Einrichtungen ist, daß der Fehler nicht lokalisierbar ist, weil ein Kurzschluß in den Wicklungen bzw. bei den Anschlußklemmen dieselbe Reaktion auslöst, wie ein Kurzschluß im Frequenzumrichter. Der Betreiber des Motors kann nur schwerlich feststellen, ob die Wicklungen des Motors bzw. deren Anschlüsse oder die Steuerung ausgetauscht werden muß, so daß es oft zum kostspieligen Austausch eigentlich noch funktionsfähiger Komponenten kommt.

Neben einem Kurzschluß sind auch andere Fehler denkbar. So ist es beispielsweise möglich, daß kein Kontakt oder ein Wackelkontakt z.B. zwischen einem Steckkontakt und einer Motorwicklung vorhanden ist. Beim Auftreten eines solchen Fehlers versagen die bekannten Systeme völlig.

Aus der US 4,949,362 ist ein System zur Feststellung und Eingrenzung von Fehlerströmen bei Tauchpumpen zum Fördern eines Flüssigmetall-Kühlmittels in nuklearen Reaktoren bekannt.

Aufgabe der Erfindung ist es daher, ein einfach zu realisierendes Verfahren zur Überwachung eines elektronisch geregelten Elektromotors zu schaffen, das eine gezielte und zuverlässige Zustands- und Fehlerdiagnose bei Inbetriebnahme und beim Betrieb des Motors gewährleistet.

Diese Aufgabe wird von einem Verfahren nach Anspruch 1 gelöst.

Es gibt zwei getrennte Verfahren, die jeweils eine Testphase darstellen. In einer ersten Testphase wird die Ansteuer- und Leistungselektronik des Frequenzumrichters auf die Funktionsfähigkeit geprüft, während in einer zweiten Testphase die Wicklungen des Elektromotors und deren Anschlüsse an die Versorgungsspannung auf einen ausreichenden Kontakt und auf einen eventuellen Kurzschluß geprüft werden. Da beide Testphasen von derselben Steuerelektronik initiiert werden, ist es besonders vorteilhaft, sie in zeitlicher Abfolge direkt hintereinander durchzuführen, um so eine umfassende Diagnose des Elektromotors zu gewährleisten. Dabei ist die Reihenfolge beliebig. Eine solche Diagnose läßt die genaue Identifikation und Lokalisation der Funktionsstörung zu.

Während der ersten Testphase wird durch gezieltes An- und Abschalten eines innerhalb des Frequenzumrichters fließenden Kurzschlußstromes im Bereich von Mikrosekunden die Schaltfähigkeit der insbesondere abschaltbaren Leistungselemente wie beispielsweise IGBT oder Power-Mos-Fet-Transistoren überprüft, ohne daß es zu einer Überlastung oder Zerstörung der Leistungselemente kommt. Da die Halbleiter des Umrichters an der gleichgerichteten Zwischenkreisspannung liegen (z.B. 330V DC bei einer 220 V Einspeisung) erfolgt die Prüfung bei der im Betrieb auftretenden hohen Spannungsbelastung.

Besonders vorteilhaft läßt sich das Verfahren zur Diagnose bei elektrisch betriebenen Kreiselpumpen, insbesondere zum Einsatz in Heizwasserkreisläufen einsetzen. Dabei kann das Verfahren zur Diagnose als Qualitätskontrolle nach der Herstellung des Motors bzw. der Pumpe oder vor dem Einbau erfolgen. Dabei ist es besonders vorteilhaft, daß das Verfahren nicht auf den Lastbetrieb angewiesen ist, da es die Fehler allein anhand interner Kreisströme diagnostizieren kann. Durch die verbesserte Qualitätssicherung ist eine Erhöhung der Lieferqualität möglich, was sich wiederum positiv auf die Herstellungskosten des Aggregates auswirkt. Dabei ist es vorteilhaft, daß das erfindungsgemäße Verfahren die vorhandenen Einrichtungen des Umrichters ausnützt und sie für die Diagnose nutzt.

Zur Durchführung des Verfahrens ist es besonders vorteilhaft, wenn die Steuerelektronik mit einem Mikroprozessor und einem dazugehörigen Schreib/Lesespeicher ausgestattet ist. In diesem Fall kann auf dem Prozessor auf Anregung von Außen oder automatisch ein Programm ablaufen, das die Testphasen durch Erzeugung der Testsignale durchführt. Dabei kann das Programm so beschaffen sein, daß es die Testphasen während des Betriebes des Aggregates in einer Art Interrupt-Steuerung getrennt vom Betriebszyklus oder parallel zum Betriebszyklus in den für einen Zyklus nicht angesteuerten Zweigen der Elektronik durchführt. Die Testphasen werden dabei während des laufenden Betriebes des Aggregates in zyklischer Wiederkehr durchgeführt. Die Testphasen können in einer auch über eine am Aggregat befindliche oder für Servicezwecke am Aggregat anbringbare Bedieneinheit initiiert werden. Eine aufsetzbare und über einen Steckkontakt mit dem Aggregat verbundene Bedieneinheit eignet sich besonders für den Service von kleinen und preiswerten Aggregaten.

Das Resultat der Diagnose bzw. der einzelnen Testphasen kann mittels einem am Elektromotor angebrachten analogen oder digitalen Kontrollinstrument oder mittels einer einfachen Statusanzeige (LED) angezeigt werden.

In einer besonders vorteilhaften Ausführungsform weist das Aggregat eine elektronische Bus-Schnittstelle auf, die den Kontakt zu einer externen und womöglich weit entfernt angeordneten Bedieneinheit erlaubt. Die Bedieneinheit kann über Infrarotsignale oder elektromagnetische Wellen anderer Wellenlänge mit der Bedieneinheit kommunizieren. Die Diagnose kann somit bequem für ein ganzes System von Aggregaten zentral von einem Rechner vorgenommen werden. Diese Art der Ferndiagnose eignet sich insbesondere für ein Heizwassersystem mit einer großen Anzahl von Pumpen. Das Ergebnis der Diffrentialdiagnose kann dabei gleich weiterverarbeitet oder zunächst auf einem zentralen Display angezeigt werden. Als Meldung kann dabei die Summenfehleraussage bezüglich des Zustandes von Leistungselektronik oder Motor oder aber eine nach Art und Ort des Fehlers spezifizierte Fehlermeldung ausgegeben werden.

Zur Durchführung der Diagnose ist es besonders vorteilhaft, wenn vor dem Mikroprozessor eine Gatterschaltung mit einstellbarem Grenzstrom angeordnet ist, die aufgrund einer im Verhältnis zur Sollstromstärke Unter- oder Überstromstärke ein Fehlersignal erzeugt, das direkt an den Signaleingang des Mikroprozessors weitergegeben wird und diesen durch einen Interrupt zum Abschalten des Aggregates oder zu einer Fehlermeldung veranlaßt. Die Gatterschaltung hat den Vorteil des geringen Zeitverlustes, der mit einer Berechnung durch den Mikroprozessor verbunden wäre.

Da das erfindungsgemäße Verfahren eine genaue Lokalisation der Funktionsstörung zuläßt, wird die Wartung der Aggregate einfacher und billiger. So brauchen nur noch die tatsächlich defekten Komponenten ersetzt oder repariert zu werden. Dabei trägt die Tatsache, daß die Funktionsstörung z.B. ein sich anbahnender Kurzschluß oder ein Wackelkontakt schon in der Entstehung entdeckt werden kann, zu einer Erhöhung der Betriebssicherheit und der Lebensdauer bei. So kann beim Auftreten eines Fehlers ein Teil der Steuerelektronik abgeschaltet werden, während das Aggregat zumindest für kurze Zeit im Notbetrieb weiterlaufen kann. Vorteilhaft ist auch, die Diagnosefunktion bei jedem Einschalten des Aggregates zu aktivieren. In dieser Ausführungsform eignet sich das Verfahren besonders für Heizungspumpen, deren Betriebsphasen auf den Bedarf im Heizungssystem ausgelegt sind und die daher häufig eingeschaltet werden.

Das erfindungsgemäße Verfahren wird im folgenden anhand der Figuren näher beschrieben. Es zeigen:

**Figur 1** Eine schematisch dargestellte elektrisch betriebene Pumpe,

**Figur 2** ein Schaltschema einer Steuerelektronik mit den Anschlüssen zu den Motorwicklungen,

**Figur 3** das zeitliche Signalverhalten in einem Umrichterzweig,

**Figur 4** das zeitliche Signalverhalten in einer Wicklung.

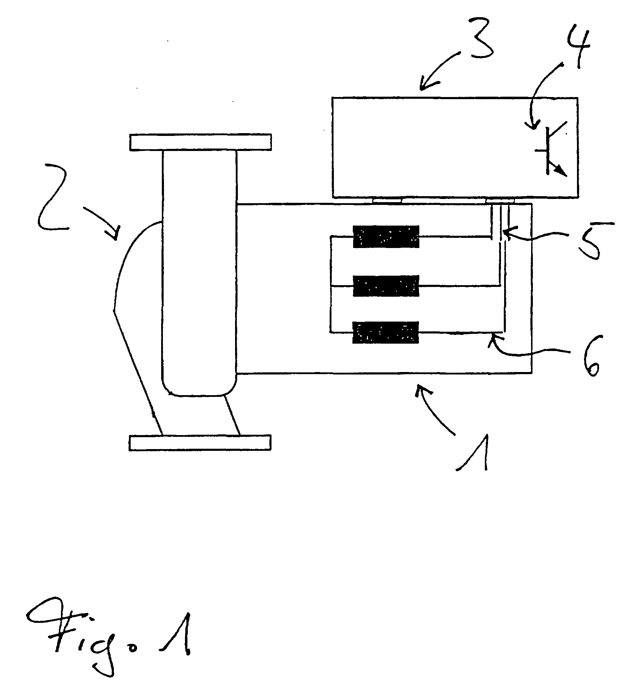

In Figur 1 sind die verschleißanfälligen, elektrischen Komponenten einer mit einem Elektromotor 1 betriebenen Kreiselpumpe 2 schematisch dargestellt. Die Pumpe 2 hat eine im Klemmenkasten 3 integrierte Steuerelektronik mit Frequenzumrichter 4 zur stufenlosen Drehzahlregelung. Die im Klemmenkasten 3 angeordnete Steuerelektronik ist über ein Stecksystem 5 mit der Wicklung 6 des Elektromotors 1, die in diesem Falle drei Schleifen hat und als Stern, Dreieck- oder Wechselstromwicklung ausgeführt sein kann, verbunden.

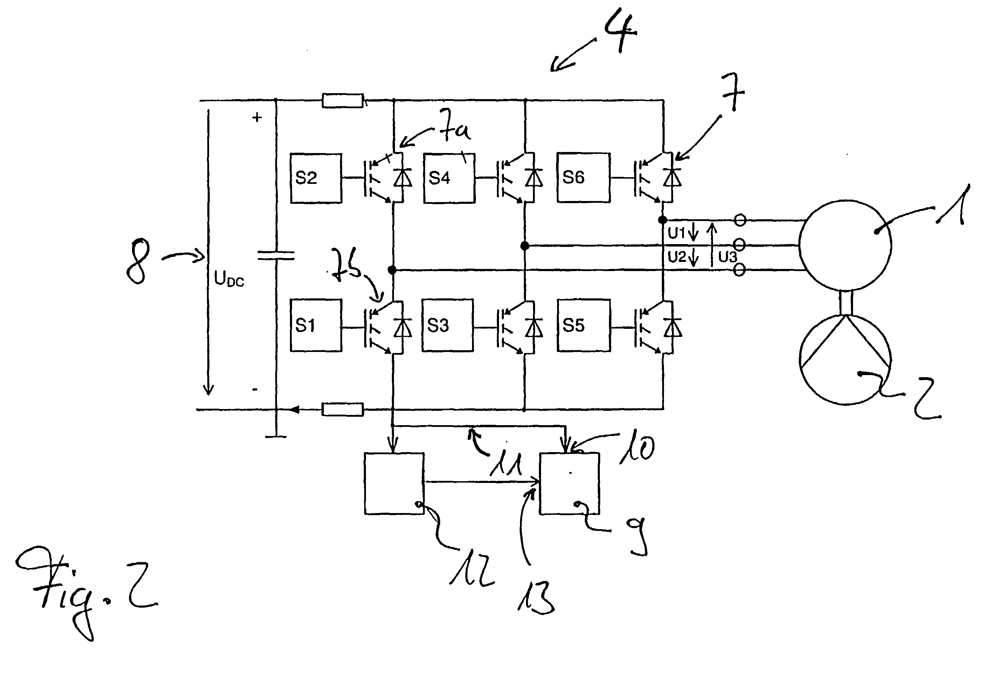

Figur 2 zeigt die typische Schaltung eines Frequenzumrichters 4 und die Verschaltung mit dem Elektromotor 1, der die Pumpe 2 betreibt. Die Schaltung weist sechs Leistungshalbleiter 7 auf, die jeweils zu Paaren zu einer Brücke einer Brückenschaltung verschaltet sind und jeweils von einem eigenen Ansteuerkreis (S1 bis S6) angesteuert werden. So wandeln die Leistungshalbleiter 7 in der Betriebsphase, d.h. im normalen Umrichterbetrieb, die Eingangsspannung 8 zu einer modulierten Ausgangsspannung (U1, U2 und U3) mit einstellbarer Frequenz und Amplitude. Die Ansteuerung der Ansteuerkreise (S1 bis S6) erfolgt mittels eines Mikroprozessors 9. Ein eventueller Kurzschluß wird vom Mikroprozessor 9 durch die Auswertung des am Eingang 10 anliegenden Stromsignales auf Leitung 11 erkannt. Der Mikroprozessor 9 erkennt den Fehler und veranlaßt eine Fehlermeldung oder die Abschaltung. Der im Frequenzumrichter auftretende Strom wird gleichfalls einer Gatterschaltung 12 zugeführt, die eine eingestellte untere und eine eingestellte obere Strombegrenzung aufweist. Überschreitet der Strom eine der Strombegrenzungen, gibt die Gatterschaltung 12 ein schelles Signal auf einen Interrupt-Eingang 13 des Mikroprozessors 9, der ohne Rechenarbeit zu vollziehen sofort eine Abschaltung des Motors 1 veranlassen kann. Durch die Gatterschaltung 12 ist eine Reaktion auf einen Kurzschluß innerhalb weniger Mikrosekunden möglich.

Bei der Diagnose des Umrichters in der einen Testphase können im wesentlichen zwei Fehler entdeckt werden.

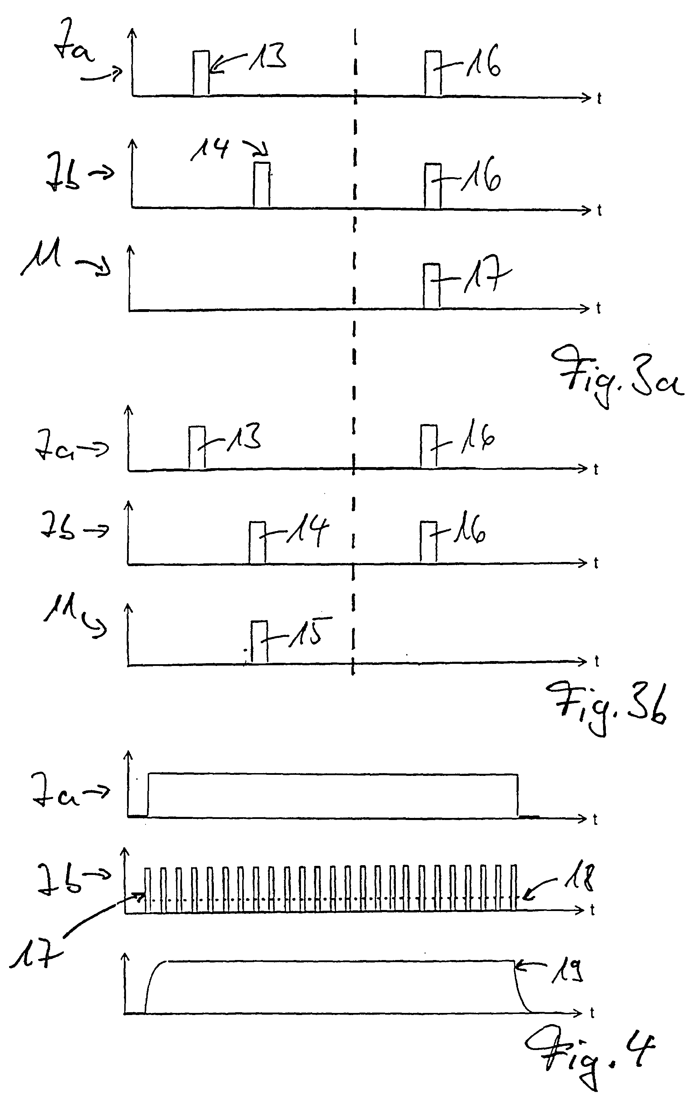

Der erste Fehler ist durch einen dauernd eingeschalteten und damit kurzgeschlossenen Leistungshalbleiter 7 verursacht. Dieser Fehler kommt beispielsweise durch Kurzschlüsse in der Ansteuerung oder durch den Verlust der Sperrfähigkeit infolge thermischer Überlastung des Leistungshalbleiters 7 zustande. Um zu überprüfen, ob in einem Brückenzweig ein Kurzschluß eines der beiden Leistungshalbleiter 7a oder 7b vorliegt, wird einer der beiden Leistungshalbleiter 7a oder 7b für einige Mikrosekunden mit einem Puls 13 angesteuert. Im vorliegenden Beispiel wird der dem Steuerkreis S1 zugeordnete Leistungshalbleiter 7a angesteuert(Fig. 3a, linke Hälfte). Wenn der Leistungshalbleiter 7b kurzgeschlossen wäre, käme es zu einem hohen Kurzschlußstrom auf der Leitung 11, der von der Gatterschaltung 12 und der Fehlerschaltung im Mikroprozessor 9 registriert wird. Anschließend wird 7b mit einem Puls 14 angesteuert. Da im vorliegenden Beispiel (Fig. 3a, linke Hälfte) beide Leistungshalbleiter keinen Kurzschluß aufweisen, schaltet keiner der Pulse auf Leitung 11 durch. Der Test nachfolgend wird für die verbleibenden beiden Brückenzweige durchgeführt.

Nach dem Beispiel in Figur 3b, linke Hälfte wird zunächst wiederum der Leistungshalbleiter 7a durch einen Puls 13 angesteuert, bevor der Leistungshalbleiter 7b durch den Puls 14 beaufschlagt wird. Die Tatsache, daß der Puls (Signal 15) auf Leitung 11 durchschaltet ist ein sicheres Zeichen für einen defekten Leistungshalbleiter 7a.

Die zweite Art von Fehler wird durch Leistungshalbleiter 7 verursacht, die bei Ansteuerung durch den Mikroprozessor 9 nicht ein- bzw. offengehalten. Ein solcher Fehler kann durch eine kalte Lötstelle, eine abgerissene Bondstelle oder durch eine Zerstörung des Halbleiterkristalls hervorgerufen sein. Um zu überprüfen, ob die Leistungshalbleiter 7 ordnungsgemäß schalten können, werden beide Leistungshalbleiter 7a und 7b gleichzeitig durch einen kurzen Steuerpuls 16 geschlossen (Fig.3a, rechte Seite). Der Steuerpuls 16 erzeugt einen Kurzschlußstrom 17, der als positiv zu deutendes Fehlersignal auf Leitung 11 erkannt wird. Tritt der Kurzschlußstrom 17 auf, so ist davon auszugehen, daß beide Leistungshalbleiter ordnungsgemäß schalten. Dabei sind die Steuerpulse so kurz, daß die Halbleiter keinen Schaden nehmen können. Die Testphase wird widerum für die verbleibenden Brückenzweige durchgeführt. Im Falle eines defekten, weil dauernd offenen Leistungshalbleiters 7a oder 7b fließt trotz des beide Leistungshalbleiter schaltenden Steuerpulses 16 kein Kurzschlußstrom auf Leitung 11 (Fig.3b, rechte Seite), was vom Mikroprozessor 9 als Fehler erkannt und gemeldet wird.

Wie dargestellt, kann der Umrichter ohne eine externe Last geprüft werden, da lediglich interne Ströme für die Diagnose benutzt werden. Liegt statt eines Halbleiterkurzschlusses ein Klemmenkurzschluß vor, so führt dieser nicht zu einer falschen Diagnose, da immer nur ein Zweig geprüft wird. Da die Testpulse sehr kurz sind, kann sich bei einem möglichen Erdschluß wegen der vorhandenen Erdimpedanz kein hoher Kurzschlußstrom entwickeln, so daß die Diagnose der Wicklungen bzw. der Kontakte auch bei Erdschluß möglich ist.

Ist die Steuerelektronik in einer Testphase auf ihre Funktionsfähigkeit hin untersucht, erfolgt in einer anschließenden Testphase die Untersuchung der Motorwicklung 6 und der Steckverbindung 5. Dazu wird durch eine an sich bekannte Pulsbreitenmodulation eine verkettete Spannung erzeugt, wobei eine mittlere Ausgangsspannung zwischen 0% und 100% der Zwischenkreisgleichspannung 8 eingestellt werden kann. Dazu wird im vorliegenden Beispiel (Figur 4) an den Halbleiter 7b eine Pulsfolge 17 hoher Frequenz angelegt, während der Halbleiter 7a kontinuierlich angesteuert ist. Die Pulsfolge 17 ergibt eine mittlere konstante Spannung 18. Bei der hohen Pulsfrequenz von einigen kHz wird sich wegen der Motor-Streuinduktivität nahezu ein Gleichstrom 19 ($I_{mess}$) einstellen, der gemessen wird, so daß bei bekanntem Modulationsgrad f und bekannter Zwischenkreisgleichspannung 8 ($U_{DC}$) der Gesamtwiderstand $R_{ges}$ über

$$R_{ges} = U / I_{mess} = f * U_{DC} / I_{mess}$$

berechnet werden kann. Dabei ist $R_{ges}$ der Widerstand zwischen den Anschlußklemmen, der je nach Verschaltung unterschiedlich ist und bei der Sternschaltung dem Doppelten und bei der Dreieckschaltung 2/3 eines Wicklungswiderstandes beträgt. Dieses Verfahren wird zyklisch für die verbleibenden beiden Brückenzweige wiederholt, so daß die Gesamtersatzwiderstände R1, R2 und R3 ermittelt und im Schreib/Lese- Speicher abgespeichert werden.

Sind alle drei Widerstände R1, R2 und R3 annähernd gleich, ist von ordnungsgemäßen Wicklungen 6 und Steckkontakten 5 auszugehen. In diesem Fall gibt der Mikroprozessor kein Fehlersignal aus. Wird aber festgestellt, daß beispielsweise der Widerstand R1 größer als der theoretische Gesamtwiderstand ist, so ist davon auszugehen, daß eine der entsprechenden Teilwicklungen oder deren Klemmverbindungen unterbrochen ist. Ist hingegen beispielsweise R1 kleiner als der theoretische Gesamtwiderstand liegt ein Wicklungskurzschluß vor.

Die Wicklungswiderstände werden in periodischen Abständen ermittelt und gespeichert, so daß ein eventueller Trend erkannt werden kann und bei Überschreiten einer einstellbaren Schwelle eine Fehlermeldung angezeigt werden kann. So läßt sich eine Schadensfrüherkennung verwirklichen.

Da es sich um eine relative Messung der Widerstände R1, R2 und R3 handelt, ist das Ergebnis unabhängig von der Wicklungstemperatur und der Verschaltung der Wicklung.

**Patentansprüche**

1. Verfahren zur Überwachung eines vermittels eines Mikroprozessors (9) gesteuerten und schaltbare Halbleiterelemente aufweisenden Frequenzumrichters eines drehzahlgeregelten Wechsel- oder Drehstrommotors (1), der insbesondere zum Antrieb von Kreiselpumpen (2) dient, wobei die Steuerelektronik in einer Betriebsphase über eine mindestens zwei zu einer Brückenschaltung verschaltete Schaltelemente (7) aufweisende Umrichterschaltung eine Versorgungsspannung (8) an die Wicklungen (6) des Elektromotors (1) anlegt, **gekennzeichnet durch** eineTestphase,

   - in der mittels eines Testsignales (17) eine Spannung (18) zwischen den Brückenzweigen erzeugt wird, die einen definierten Stromfluß in einer Wicklung (6) des Elektromotors (1) erzeugt,
   - in der der **durch** das Testsignal (17) erzeugte Strom gemessen und daraus der tatsächliche Widerstand einer Wicklung berechnet wird und
   - in der der tatsächliche Wicklungswiderstand mit dem theoretischen Wicklungswiderstand oder den Widerständen der anderen Wicklungen verglichen und die mögliche Differenz bewertet wird.

2. Verfahren nach Anspruch 1,
   **dadurch gekennzeichnet, daß** das Testsignal (17) eine Pulsfolge aufweist, die eine verkettete Spannung zwischen den Brückenzweigen erzeugt.

3. Verfahren nach Anspruch 1 oder 2,
   **dadurch gekennzeichnet, daß** durch Pulsbreitenmodulation die mittlere Ausgangsspannung zwischen 0% und 100% der Zwischenkreis-Gleichspannung (8) veränderbar ist.

4. Verfahren nach einem der vorherigen Ansprüche,
   **dadurch gekennzeichnet, daß** die Schwankung der Stromstärke durch Veränderung der Pulsfrequenz einstellbar ist.

5. Verfahren nach einem der vorherigen Ansprüche,
   **dadurch gekennzeichnet, daß** in der Testphase alle Wicklungen (6) des Elektromotors (1) in zyklischer Reihenfolge nacheinander auf ihre Funktionsfähigkeit hin überwacht werden.

6. Verfahren nach einem der vorherigen Ansprüche,
   **dadurch gekennzeichnet, daß** die Wicklungswiderstände periodisch ermittelt werden.

7. Verfahren nach einem der vorherigen Ansprüche,
   **dadurch gekennzeichnet, daß** die gemessenen Stromstärken und/oder die errechneten Widerstände zur weiteren Auswertung in einem Schreib/Lesespeicher abgespeichert werden.

8. Verfahren nach einem der vorherigen Ansprüche,
   **dadurch gekennzeichnet, daß** eine ermittelte Differenz zwischen dem gemessenen Widerstand einer Wicklung und dem theoretischen Widerstand bzw. den Widerständen der anderen Wicklungen zu einer Fehlermeldung führt.

9. Verfahren nach einem der vorherigen Ansprüche,
   **dadurch gekennzeichnet, daß** die Testphase von einem vom Mikroprozessor (9) ausgeführten Programm initiiert wird.

10. Verfahren nach einem der vorherigen Ansprüche,
    **dadurch gekennzeichnet, daß** im Falle einer vorhendenen Kreiselpumpe die Testphase über eine an der Pumpe anbringbare Bedieneinheit initiiert wird.

11. Verfahren nach einem der vorherigen Ansprüche,
    **dadurch gekennzeichnet, daß** die Testphase über einen externen, mit der Steuerelektronik über eine Schnittstelle, insbesondere über eine mechanische, über eine infrarotgesteuerte oder über eine funkgestützte Schnittstelle, verbundenen Rechner initiiert wird.

12. Verfahren nach einem der vorherigen Ansprüche,
    **dadurch gekennzeichnet, daß** der Elektromotor (1) mehrere, insbesondere drei Wicklungen (6) und die Steuerelektronik eine Brückenschaltung mit einer entsprechenden Zahl von Brückenzweigen aufweist.

13. Verfahren nach einem der vorherigen Ansprüche,
    **dadurch gekennzeichnet, daß** die Testphase zur Qualitätskontrolle direkt nach Fertigung des Elektromotors initiiert wird.

14. Verfahren nach einem der vorherigen Ansprüche,
    **dadurch gekennzeichnet , daß** im Falle einer vorhendenen Kreiselpumpe die Testphase bei jedem Einschalten der Pumpe automatisch initiiert wird.

15. Verfahren nach einem der vorherigen Ansprüche,
    **dadurch gekennzeichnet, daß** im Falle einer vorhendenen Kreiselpumpe die Testphase während des laufenden Betriebes der Pumpe in zyklischer Wiederkehr initiiert wird.

16. Verfahren nach einem der vorherigen Ansprüche,
    **dadurch gekennzeichnet, daß** das Resultat der Testphase mittels einer am Elektromotor angebrachten Kontrollanzeige oder auf einem mit dem Elektromotor in Verbindung stehenden Display angezeigt wird.

## Claims

1. Method for monitoring a microprocessor (9) controlled frequency converter having switchable semiconductor elements and forming part of an adjustable-speed a.c. or three-phase motor (1) used in particular for driving centrifugal pumps (2), in an operating phase the control electronics applying a supply voltage (8) to the windings (6) of the electric motor (1) via a converter circuit having at least two switch elements (7) wired to a bridge circuit, **characterised by** a test phase

   - in which by means of a test signal (17) a voltage (18) is generated between the branches of the bridge and this generates a defined flow of current in a coil (6) of the electric motor (1),
   - in which the current generated by the test signal (17) is measured and from it the actual resistance of a winding is calculated and
   - in which the actual winding resistance is compared with the theoretical winding resistance or the resistances of the other windings and the potential difference is rated.

2. Method according to claim 1, **characterised in that** the test signal (17) features a pulse sequence that generates a line-to-line voltage between the branches of the bridge.

3. Method according to claim 1 or 2, **characterised in that** the mean output voltage can be varied between 0% and 100% of the d.c. link voltage (8) by pulse-width modulation.

4. Method according to any of the preceding claims, **characterised in that** the fluctuation in current strength can be adjusted by varying the pulse frequency.

5. Method according to any of the preceding claims, **characterised in that** in the test phase all the windings (6) of the electric motor (1) are monitored one after the other in a cyclic sequence to check their operating efficiency.

6. Method according to any of the preceding claims, **characterised in that** the winding resistances are ascertained periodically.

7. Method according to any of the preceding claims, **characterised in that** the measured current strengths and/or the calculated resistances are stored in a read/write memory for further evaluation.

8. Method according to any of the preceding claims, **characterised in that** any difference found between the measured resistance of one winding and the theoretical resistance or resistances of the other windings results in an error message.

9. Method according to any of the preceding claims, **characterised in that** the test phase is initiated by a program executed by the microprocessor (9).

10. Method according to any of the preceding claims, **characterised in that** if a centrifugal pump is present, the test phase is initiated via a control unit which can be mounted on the pump.

11. Method according to any of the preceding claims, **characterised in that** the test phase is initiated via an external computer connected to the control electronics via an interface, more particularly via a mechanical, infra-red or radio-controlled interface.

12. Method according to any of the preceding claims, **characterised in that** the electric motor (1) has multiple windings (6), notably three, and the control electronics has a bridge circuit with a corresponding number of bridge branches.

13. Method according to any of the preceding claims, **characterised in that** for quality control the test phase is initiated directly after manufacture of the electric motor.

14. Method according to any of the preceding claims, **characterised in that** if a centrifugal pump is present the test phase is automatically initiated every time the pump is switched on.

15. Method according to any of the preceding claims, **characterised in that** if a centrifugal pump is present the test phase is initiated so as to recur cyclically whilst the pump is running.

16. Method according to any of the preceding claims, **characterised in that** the result of the test phase is displayed by means of a pilot display mounted on the electric motor or on a display communicating with the electric motor.

## Revendications

1. Procédé pour le contrôle d'un changeur de fréquence d'un moteur à courant alternatif ou un courant triphasé (1) à réglage de vitesse de rotation, présentant des éléments semi-conducteurs commandés et commutables au moyen d'un microprocesseur (9), qui sert en particulier à l'entraînement de pompes centrifuges (2), l'électronique de commande mettant en contact, dans une phase de fonctionnement, une tension d'alimentation (8) aux bobines (6) du moteur électrique (1) par l'intermédiaire d'un circuit de changeur de fréquence présentant au moins deux éléments de commutation (7) commutés en un circuit pont,
**caractérisé par** une phase de test,

- dans laquelle une tension (18) est engendrée, au moyen d'un signal de test (17), entre les branches de pont et qui engendre une conduction de courant définie dans une bobine (6) du moteur électrique (1 ),
- dans laquelle le courant engendré par le signal de test (17) est mesuré et la résistance effective d'une bobine en est calculée et
- dans laquelle la résistance effective est comparée à la résistance de bobine théorique ou aux résistances des autres bobines et la différence possible est évaluée.

2. Procédé selon la revendication 1,
   **caractérisé en ce que** le signal de test (17) présente un train d'impulsions qui engendre une tension composée entre les branches de pont.

3. Procédé selon la revendication 1 ou 2,
   **caractérisé en ce que** la tension de sortie moyenne peut être modifiée entre 0% et 100% de la tension continue de circuit intermédiaire (8) par une modulation de largeur d'impulsions.

4. Procédé selon l'une des revendications précédentes,
   **caractérisé en ce que** la variation de l'intensité de courant peut être réglée par modification de la fréquence des impulsions.

5. Procédé selon l'une des revendications précédentes,
   **caractérisé en ce que**, dans la phase de test, toutes les bobines (6) du moteur électrique (1) sont contrôlées, en ce qui concerne leur capacité de fonctionnement, les unes après les autres en succession cyclique.

6. Procédé selon l'une des revendications précédentes,
   **caractérisé en ce que** les résistances des bobines sont détectées périodiquement.

7. Procédé selon l'une des revendications précédentes,
   **caractérisé en ce que** les intensités de courant mesurées et/ou les résistances calculées sont mémorisées dans une mémoire à lecture-écriture pour une exploitation supplémentaire.

8. Procédé selon l'une des revendications précédentes,
   **caractérisé en ce que** la différence détectée entre la résistance mesurée d'une bobine et la résistance théorique ou respectivement les résistances des autres bobines conduit à un message d'erreur.

9. Procédé selon l'une des revendications précédentes,
   **caractérisé en ce que** la phase de test est initiée par un programme exécuté par le microprocesseur (9).

10. Procédé selon l'une des revendications précédentes,
    **caractérisé en ce que**, dans le cas d'une pompe centrifuge existante, la phase de test est initiée par l'intermédiaire d'une unité de manoeuvre pouvant être montée sur la pompe.

11. Procédé selon l'une des revendications précédentes,
    **caractérisé en ce que** la phase de test est initiée par un calculateur externe relié à l'électronique de commande par l'intermédiaire d'un interface, en particulier par l'intermédiaire d'un interface commandé par infrarouge ou par l'intermédiaire d'un interface à support radio.

12. Procédé selon l'une des revendications précédentes,
    **caractérisé en ce que** le moteur électrique (1) présente plusieurs bobines (6), en particulier trois, et l'électronique de commande présente un circuit pont avec un nombre correspondant de branches de pont.

13. Procédé selon l'une des revendications précédentes,
    **caractérisé en ce que** la phase de test est initiée directement après la fabrication du moteur électrique pour le contrôle de qualité.

14. Procédé selon l'une des revendications précédentes,
    **caractérisé en ce que**, dans le cas d'une pompe centrifuge existante, la phase de test est initiée automatiquement lors de chaque mise en marche de la pompe.

15. Procédé selon l'une des revendications précédentes,
    **caractérisé en ce que**, dans le cas d'une pompe centrifuge existante, la phase de test est initiée en récurrence cyclique pendant le fonctionnement continu de la pompe.

**16.** Procédé selon l'une des revendications précédentes,
**caractérisé en ce que** le résultat de la phase de test est affiché au moyen d'un afficheur de contrôle monté sur le moteur électrique ou sur un afficheur se trouvant en liaison avec le moteur électrique.

Fig. 1

Fig. 2

EP 0 981 056 B1

7a → 13 16

7b → 14 16

11 → 17

Fig. 3a

7a → 13 16

7b → 14 16

11 → 15

Fig. 3b

7a →

7b → 18

17

19

Fig. 4